# EUROPÄISCHE PATENTSCHRIFT

(11) **EP 0 613 255 B1**
(45) Veröffentlichungstag und Bekanntmachung des Hinweises auf die Patenterteilung: **20.10.1999**
(21) Anmeldenummer: 94102197.4
(22) Anmeldetag: 12.02.1994
(51) Int. Cl.: H03L 7/24

(54) **Mikrowellengenerator mit optischer Injektionssynchronisation**
Microwave generator using optical injection locking
Générateur de micro-ondes avec verrouillage par injection optique

(30) Priorität: 20.02.1993 DE 4305254
(43) Veröffentlichungstag der Anmeldung: 31.08.1994
(73) Patentinhaber: ALCATEL, 75008 Paris (FR)
(72) Erfinder: Heidemann, Rolf, Dr., D-71732 Tamm (DE)
(74) Vertreter: Schätzle, Albin, Dipl.-Phys.

(56) Entgegenhaltungen:
- GB-A- 2 179 817
- US-A- 4 849 716
- ELECTRONICS LETTERS, Bd. 28, Nr. 7, 01 März 1992, STEVENAGE ,GB, Seiten 621 - 623 A. BANGERT ET. AL. 'INITIAL OBSERVATIONS OF OPTICAL INJECTION LOCKING OF OSCILLATORS USING HETEROJUNCTION BIPOLAR TRANSISTORS'
- IEEE TRANSACTIONS OF MICROWAVE THEORY AND TECHNIQUES, Bd.37, Nr.10, 1. Oktober 1989, NEW,YORK,US Seiten 1512 - 1518 R. ESMAN ET. AL. 'OPTICAL PHASE CONTROL OF AN OPTICALLY INJECTION-LOCKED FET MICROWAVE OSCILLATOR'

## Beschreibung

Die Erfindung betrifft einen Mikrowellengenerator, dessen Mikrowellenfrequenz mittels einer Referenzfrequenz eines Referenzsignals auf optischem Wege phasenstarr synchronisiert ist, wobei mindestens einem Bereich einer elektronischen Schaltungsanordnung des Mikrowellenoszillators ein optisches Referenzträgersignal zugeführt wird, das mit der Referenzfrequenz moduliert ist.

Aus der Literaturstelle "Optical Control of Microwave Devices", Rainee Simons, Artech House, Chapter 10.5 "Direct Optical Injection-Locking and Tuning of CW Oscillators" ist ein Mikrowellenoszillator bekannt, dessen Oszillatorfrequenz auf optoelektronischem Wege stabilisiert wird. Man spricht hier vom sogenannten Injection-Locking. Damit ist eine Frequenzstabilisierung auf rein optischem Wege möglich.

Aus der Veröffentlichung "Initial Observations of Optical Injection Locking of Oscillators using Heterojunction Bipolar Transistors", A. Bangert, Th. Lauterbach, Electronic Letters, 28(1992) 26 March, No.7 ist die Erzeugung von Mikrowellenträgern mittels eines injektionssynchronisierten Oszillators bekannt. Der Oszillator erzeugt die Mikrowellenträger, wobei die jeweilige Schwingschaltung über eine modulierbare Lichtquelle optisch anregbar ist. Es werden dazu identische Halbleiterbauelemente und eine definierte optische Wellenlänge verwendet. Mit einem solchen Aufbau kann ein Mikrowellenoszillator in seinem Frequenzgang durchgestimmt werden.

Auch aus der Veröffentlichung " Optical Phase Control of an Optically Injection-Locked FET Mircowave Oscillator", R. Esman, L. Goldberg, J.F. Weller, 8099 IEEE Transactions on Microwave Theory and Techniques, 37 (1989) October, No. 10 ist ein Mikrowellenoszillator bekannt, der mit einer optischen Quelle frequenzgesteuert wird.

Ausgehend von diesem Stand der Technik liegt der Erfindung die Aufgabe zugrunde, sowohl eine Frequenzstabilisierung als auch eine Steuerung (Modulatation, Abstimmung usw.) eines Mikrowellengenerators auf rein optischem Wege zu bewirken.

Diese Aufgabe wird erfindungsgemäß dadurch gelöst, daß die Schaltungsanordnung zwei Bauelemente auf der Basis unterschiedlicher Halbleitertypen aufweist, die derart gewählt sind, daß das eine, erste, einem ersten Halbleitertyp angehörende Bauelement optisch auf das Referenzträgersignal und somit auf die Referenzfrequenz zur Erzielung der Synchronisierung anspricht, und daß das andere, zweite, einem zweiten Halbleitertyp angehörende Bauelement -unabhängig von dem Ansprechen des ersten Bauelements- auf ein in der Frequenz vom Referenzträgersignal abweichendes optisches Steuerungträgersignal reagiert, mit dessen aufmoduliertem Steuersignal eine Steuerung der Amplitude des ersten Bauelements erfolgt.

Aufgrund dieser Ausbildung lassen sich mittels zweier getrennter Wellenlängen auf optischem Wege das Injection-Locking und auch eine Steuerung, zum Beispiel Modulation, durchführen. Genutzt wird dabei der aufgrund der Wahl der Halbleitertypen vorliegende unterschiedliche Bandabstand im Hinblick auf ein photoelektrisches Ansprechen dieser Bauelemente. Der eine Halbleitertyp reagiert auf das optische Referenzträgersignal; der andere Halbleitertyp spricht auf das optische Steuerungsträgersignal an. Der eine, erste Halbleitertyp wird für die Realisierung der Schwingschaltung des Mikrowellengenerators eingesetzt und der andere, zweite Halbleitertyp dient der Ansteuerung der Schwingschaltung im Hinblick auf dessen Amplitude. Insofern ist mit dem auf das Steuerungsträgersignal aufmodulierte Steuersignal eine Amplitudenmodulation der am Ausgang des Mikrowellengenerators zur Verfügung stehenden Mikrowelle möglich. Dabei kann auch derart vorgegangen sein, daß der Generator mittels des Steuersignals ein- und ausgeschaltet, also getastet, wird. Auch hierdurch ist eine Informationsübertragung möglich.

Nach einer Weiterbildung der Erfindung ist vorgesehen, daß die Bauelemente beider Halbleitertypen auf einem gemeinsamen Wafer (Substrat), vorzugsweise monolitisch in einem Schaltkreis integriert, angeordnet sind.

Vorteilhaft ist es, wenn die Halbleitertypen Silizium (Si) aufweisen. Nach einem bevorzugten Ausführungsbeispiel ist vorgesehen, daß der erste Halbleitertyp mindestens ein Silizium-Germanium-Transistor, insbesondere ein Silizium-Germanium-Hetero-Bipolar-Transistor (Si-Ge HBT) ist. Dieser Halbleitertyp reagiert photoelektrisch vorzugsweise auf Licht mit einer Wellenlänge von ca. 1,3 µm.

Das Bauelement des zweiten Halbleitertyps ist -nach einem bevorzugten Ausführungsbeispiel der Erfindung- mindestens ein Silizium-Biopolar-Transistor (Si-bip.T). Der zweite Halbleitertyp reagiert photoelektrisch insbesondere nur auf Licht mit einer Wellenlänge von ca. 800 bzw. 980nm und nicht auf Licht mit einer Wellenlänge von ca. 1,3 µm. Auf diese Art und Weise erfolgt ein Ansprechen der beiden Halbleitertypen auf unterschiedliche Wellenlängen der Signale.

Wie bereits erwähnt, gehört das Bauelement des ersten Halbleitertyps einer Schwingschaltung des Mikrowellengenerators an. Das Bauelement des zweiten Halbleitertyps ist in einer die Schwingschaltung versorgenden Stromversorgungsschaltung (z.B. integrierte Stromquelle) des Mikrowellengenerators angeordnet.

Vorzugsweise wird das Steuersignal derart gewählt, daß es die Schwingschaltung des Mikrowellengeneratorsin einem die phasenstarre Kopplung bewirkenden Haltebereich hält.

Nach einem anderen Ausführungsbeispiel der Erfindung kann jedoch auch vorgesehen sein, daß das Referenzträgersignal nicht nur ein Referenzsignal sondern mehrere, in der Frequenz unterschiedliche Referenzsignale aufweist, da das Steuersignal nicht nur die Amplitude, sondern im unsynchronisiertem Zustand auch die Frequenz des Oszillators beeinflußt. Das Steuersignal ist vorzugsweise dann derart veränderbar, daß es die Schwingschaltung unter Verlassen ihres momentanen, einem der Referenzsignale zugeordneten Haltebereichs in einen anderen, einem anderen der Referenzsignale zugeordneten Haltebereich, gegebenenfalls unter Durchlaufen eines Freilaufbereichs, umsteuert. Die Schaltung wirkt als Frequenz- und Kanalselektor.

Die Zeichnungen veranschaulichen die Erfindung anhand von Ausführungsbeispielen und zwar zeigt:
- Figur 1: eine schematische Ansicht eines Schaltungsaufbaues eines Mikrowellen generators und optische Quellen zur Synchronisation und Steuerung sowie dazugehörige Diagramme,
- Figur 2: ein Prinzipschaltbild des Mikrowellengenerators,
- Figur 3: ein anderes Ausführungsbeispiel eines Schaltungsaufbaues und
- Figuren 4 bis 6: verschiedene Diagramme.

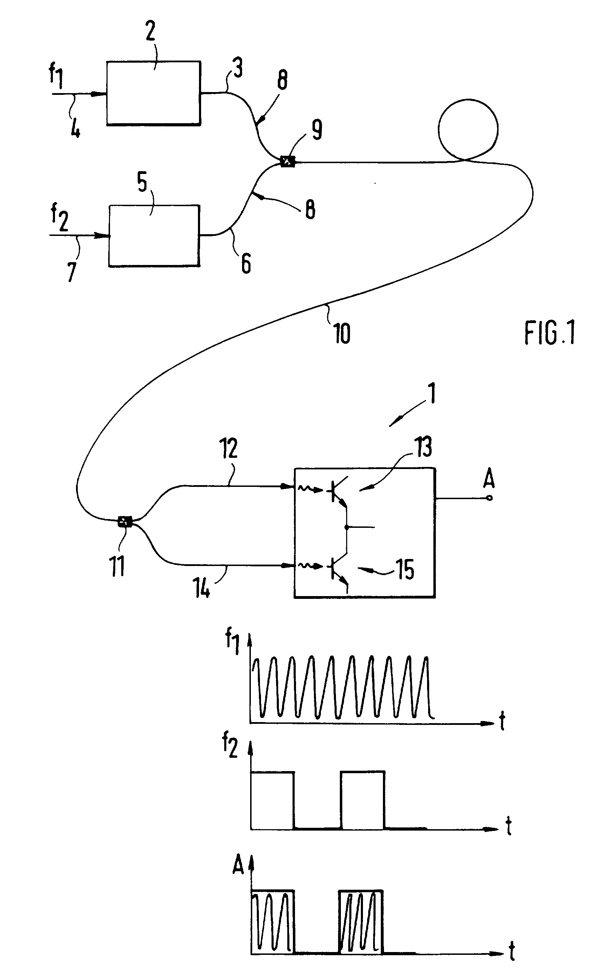

Die Figur 1 zeiat ein Ausführungsbeispiel eines Mikrowellengenerators 1. Ein optischer Sender 2 erzeugt ein optisches Referenzträgersignal 3 mit einer Wellenlänge von 1,3 µm. Das Referenzträgersignal 3 wird mit einer Referenzfrequenz f₁ eines Referenzsignals 4 moduliert. Beispielsweise weist das Referenzsignal 4 eine Frequenz von 30 GHz auf. Ein zweiter optischer Sender 5 erzeugt ein optisches Steuerungsträgersignal 6, beispielsweise mit einer Wellenlänge von 800nm. Das optische Steuerungsträgersignal 6 wird moduliert mit einer Steuerfrequenz f₂ eines Steuersignals 7. Über Lichtwellenleiter 8 werden die beiden modulierten Signale 3 und 6 einem im Multiplex-Betrieb arbeitenden Faserkoppler 9 zugeführt und über eine optische Faserstrecke 10 (Lichtwellenleiter) zu einem weiteren, ebenfalls im Multiplex-Betrieb arbeitenden Faserkoppler 11 geführt und dort wieder aufgetrennt. Über einen Lichtwellenleiter 12 wird das mit dem Referenzsignal 4 modulierte Referenzträgersignal 3 zu einer Schwingschaltung 13 des Mikrowellengenerators 1 übertragen. Das mittels eines Lichtwellenleiters 14 übertragene, mit dem Steuersignal 7 modulierte Steuerungsträgersignal 6 wird zu einer Steuerschaltung 15 des Mikrowellengenerators 1 geführt.

Die Figur 1 weist drei Diagramme auf. Das obere zeigt das Referenzsignal 4 in Abhängigkeit von der Zeit. Das mittlere Diagramm zeigt das Steuersignal 7 ebenfalls in Abhängigkeit von der Zeit. Am Ausgang A des Mikrowellengenerators 1 steht das in dem unteren Diagramm wiedergegebene Ausgangssignal zur Verfügung. Es ist ein Mikrowellensignal, gebildet aufgrund der Überlagerung des Referenzsignals mit dem Steuersignal. Wie erkennbar, wird aufgrund des Steuersignals der Mikrowellengenerator 1 ein- und ausgeschaltet, das heißt, es liegt eine digitale Betriebsart vor. Denkbar ist es jedoch auch, eine Amplitudenmodulation des am Ausgang A zur Verfügung stehenden Mikrowellensignals mittels des Steuersignals 7 vorzunehmen, also nicht eine Ein- und Ausschaltung, sondern lediglich eine Variation in der Amplitude.

Das Mikrowellensignal am Ausgang A ist frequenzstarr. Dies wird durch das Referenzsignals 4 bewirkt. Um eine optische Übertragung vornehmen zu können, ist das Referenzträgersignal 3 erforderlich, auf das das Referenzsignal 4 aufmoduliert ist. Das Referenzsignal 4 wird von einer beliebigen Einrichtung frequenzstabil erzeugt und dient dazu, den Mikrowellengenerator 1 aufgrund des sogenannten Injection-Locking frequenzstarr zu synchronisieren. Durch die Zuführung des optischen Referenzträgersignals 3 auf die Schaltungsanordnung des Mikrowellengenerators 1 wird ein photoelektrischer Effekt erzielt, so daß die Schwingschaltung 13 auf das Referenzsignal 4 und somit auf die Referenzfrequenz f₁ reagieren kann. Hierdurch erfolgt die Frequenzsynchronisation.

Ein photoelektrischer Effekt tritt ebenfalls zwischen der Schaltungsanordnung des Mikrowellengenerators 1 und dem Steuerungsträgersignal 6 auf, so daß das Steuersignal 7 Einfluß auf die Steuerschaltung 15 nehmen kann.

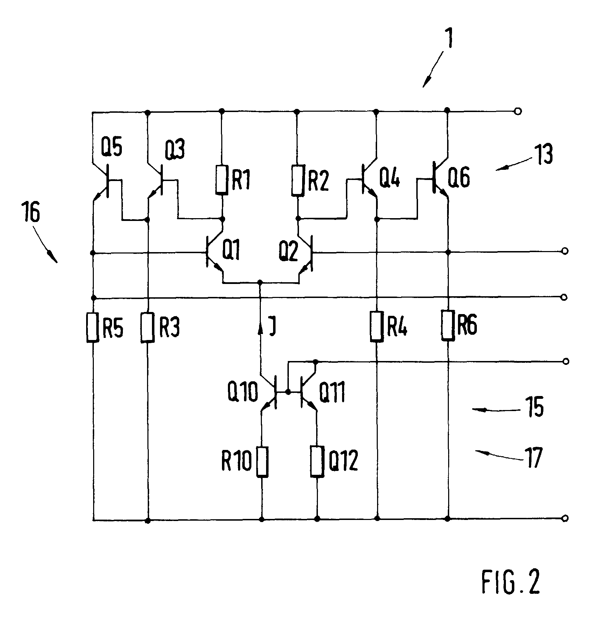

In der Figur 2 ist der Schaltungsaufbau des Mikrowellenoszillators 1 prinzipiell dargestellt. Im oberen Bereich weist die Schaltungsanordnung 16 Halbleiter Q1, Q2, Q3, Q4, Q5 und Q6 auf. Diese Bauelemente sind als Transistoren ausgebildet. Die vorstehend genannten Halbleiter gehören der Schwingschaltung 13 an. Diese bildet quasi eine HF-Stufe. Im unteren Bereich der Schaltungsanordnung 16 befinden sich die Halbleiter Q10 und Q11, die der Steuerschaltung 15 angehören. Diese Bauelemente sind ebenfalls als Transistoren ausgebildet. Die Halbleiter Q1 bis Q6 gehören einem ersten Halbleitertyp und die Halbleiter Q10 und Q11 einem zweiten Halbleitertyp an. Beide Halbleitertypen sind auf Siliziumsubstrat integriert. Vorzugsweise ist der erste Transistortyp mit Silizium-Germanium-Halbleitermaterial als Silizium-Germanium-Hetero-Bipolar-Transistor (Si-Ge HBT) ausgebildet. Bei dem zweiten Transistortyp handelt es sich um einen Silizium-Bipolar-Transistor (Si-bip.T).

Die Anordnung ist nun so getroffen, daß das von den Lichtwellenleitern 12 und 14 zugeführte Licht jeweils mindestens auf einen Transistor der Schwingschaltung 13 und auf einen Transistor der Steuerschaltung 15 trifft. Und zwar derart, daß die Schwingschaltung 13 das mit dem Referenzsignal 4 modulierte Referenzträgersignal 3 und die Steuerschaltung 15 das mit dem Steuersignal 7 modulierte Steuerungsträgersignal 6 erhält. Auf diese Art und Weise erfolgt über photoelektrische Effekte eine Beeinflussung, derart, daß die Schwingschaltung 13 auf die Referenzfrequenz f₁ des Referenzsignals 4 synchronisiert wird, wodurch das sogenannte Injection-Locking erzielt ist. Dies bedeutet, daß der Mikrowellengenerator 1 phasenstarr mit der Referenzfrequenz f₁ schwingt. Mittels des Steuersignals 7 läßt sich der in die Schwingschaltung 13 hineinfließende Strom I einstellen. Die Transistoren Q10 und Q 11 bilden zusammen mit ihrer Beschaltung somit eine Stromversorgungsschaltung 17 für die HF-Stufe des Mikrowellengenerators 1.

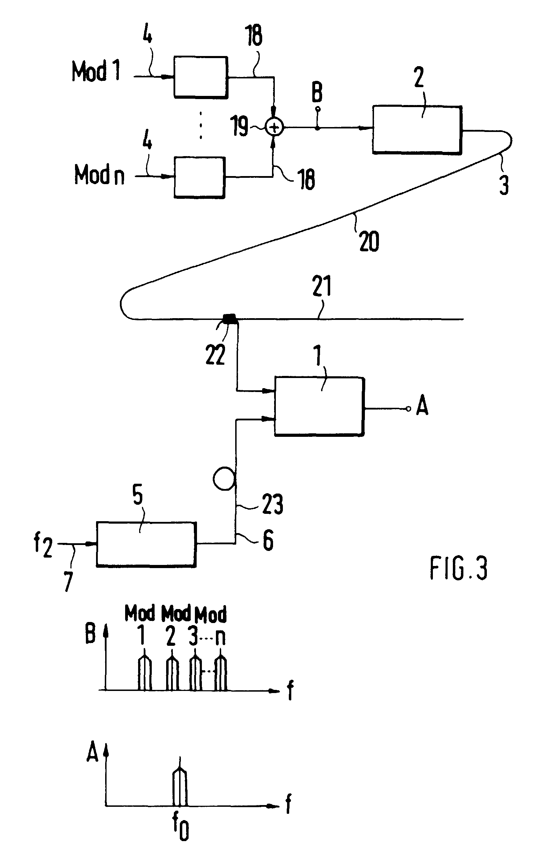

Die Figur 3 zeigt ein weiteres Ausführungsbeispiel der Erfindung, das sich gegenüber dem Ausführungsbeispiel der Figur 1 insbesondere dadurch unterscheidet, daß nicht nur ein Referenzsignal, sondern eine Vielzahl von Referenzsignalen 4 mit unterschiedlichen Frequenzen vorliegen. Diese verschiedenen Referenzsignale sind als Modulationssignale Modl bis Modn gekennzeichnet. Sie werden über Leiter 18 einem Summenpunkt 19 zugeführt. Am Ausgang B des Summenpunkts 19 steht dann das Signal gemäß dem oberen Diagramm der Figur 3 zur Verfügung. Gezeigt sind dort die verschiedenen Modulationssignale Modl ... Modn mit jeweiligen Mikrowellenunterträgern, die einen Informationsgehalt aufweisen können. Das/die Referenzsignale 4 bzw. Modl ... Modn können in der Frequenz oder Phase moduliert sein. Im "gelockten" Betrieb folgt der Generator 13 diesen Frequenz- oder Phasenänderungen. Auf diese Weise ist frequenz- oder phasenmodulierte Übertragung möglich.

Der Ausgang B des Summenpunktes 19 ist an einen optischen Sender 2 angeschlossen, der -wie beim Ausführungsbeispiel der Figur 1- eine Wellenlänge von 1,3µm aufweist. Das so gebildete optische Referenzträgersignal 3, das mit den verschiedenen Referenzsignalen 4 moduliert ist, wird dann über einen Lichtwellenleiter 20, der z. B. einen Faserbus 21 (im Falle der Steuerung von mehreren Generatoren ) bildet, zu einem Faserkoppler 22 geführt, der eine Auskopplung vornimmt und das ausgekoppelte Signal dem Mikrowellengenerator 1 zuführt.

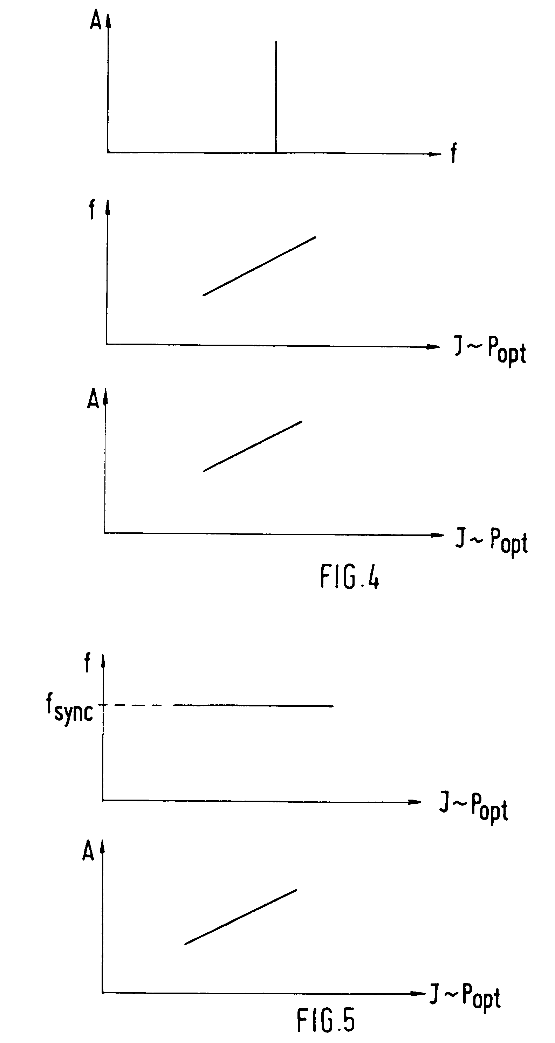

Einem optischen Sender 5 wird -ebenso wie beim Ausführungsbeispiel der Figur 1- ein Steuersignal 7 mit der Steuerfrequenz f₂ zugeführt und über einen Lichtwellenleiter 23 das mit der Steuerfrequenz überlagerte Steuerungsträgersignal 6 zur Steuerschaltung 15 des Mikrowellengenerators 1 übertragen. Aufgrund dieser Anordnung ist es möglich, den Mikrowellengenerator 1 wahlweise auf eine der verschiedenen Referenzfrequenzen Mod1 ... Modn gemäß dem Injection-Locking zu synchronisieren, wobei die Auswahl der Referenzfrequenz mittels des Steuersignals 7, insbesondere fernsteuerbar, möglich ist. Das untere Diagramm der Figur 2 zeigt den Ausgang des Mikrowellen generators 1 in Abhängigkeit von der Frequenz, wobei die Frequenz f₀ die mittlere Frequenz des Mikrowellengenerators 1 darstellt; die momentane Frequenz wird durch den entsprechenden Kanal bestimmt. Es ist zum Beispiel möglich, diese Anordnung als abstimmbares aktives Filter einzusetzen. Wie die Funktionsweise im einzelnen erfolgt, wird anhand der Figuren 4 bis 6 nachstehend näher erläutert.

Im oberen Diagramm der Figur 4 wird der Ausgang des Mikrowellengenerators 1 des Ausführungsbeispiels der Figur 3 in Abhängigkeit von der Frequenz gezeigt. Es ist erkennbar, daß eine ganz bestimmte Frequenz erzeugt wird, wobei unterstellt wird, daß die Steuerschaltung 15 der Schwingschaltung 13 des Generators einen konstanten, bestimmten Strom liefert. Unterstellt sei bei den Diagrammen der Figur 4 ferner, daß kein Referenzsignal 4, also auch kein Referenzträgersignal 3 vorliegt, das heißt, der Mikrowellengenerator 1 befindet sich in einem freischwingenden Zustand; er wird nicht durch das Licht des optischen Senders 2 synchronisiert. Wird -gemäß dem mittleren Diagramm der Figur 4- der von der Stromversorgungsschaltung 17 gelieferte Strom I, der einer optischen Leistung Pₒₚₜ entspricht, vergrößert, so steigt die Frequenz f am Ausgang des Mikrowellengenerators 1. In entsprechender Weise steigt die Amplitude am Ausgang A des Mikrowellengenerators 1, wenn der Strom I vergrößert wird. Dies ist dem unteren Diagramm der Figur 4 zu entnehmen.

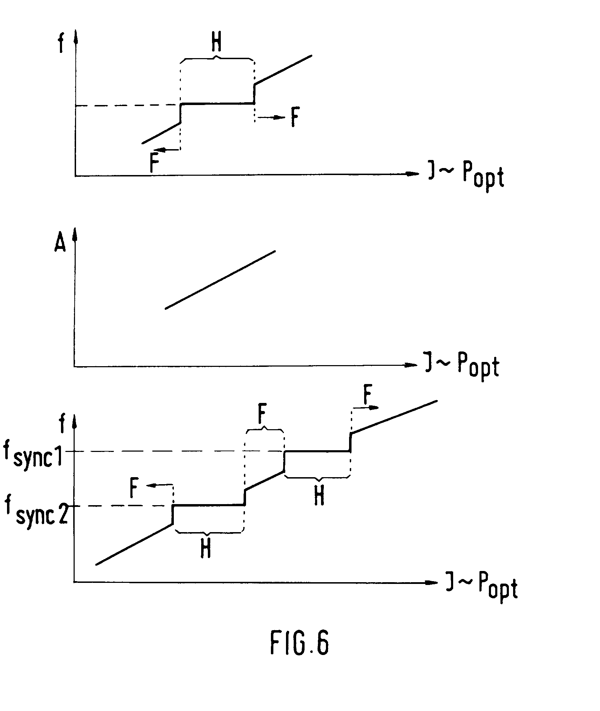

Wird im Gegensatz dazu gemäß den Diagrammen der Figur 5 ein Referenzsignal 4 mittels eines optischen Referenzträgersignals 3 dem Chip des Mikrowellengenerators 1 zugeführt, so folgt in Abhängigkeit des Stromes I keine Frequenzänderung, das heißt, es liegt die synchronisierte Frequenz f_{sync} gemäß dem oberen Diagramm der Figur 5 vor. Bei einer Stromänderung vergrößert sich nur die Amplitude am Ausgang A des Mikrowellengenerators 1.

Die Figur 4 zeigt somit einen freilaufenden Betrieb des Mikrowellengenerators 1, während die Figur 5 den synchronisierten Betrieb, also den Zustand Injection-Locking zeigt.

Im oberen Diagramm der Figur 6 ist dieser Injection-Locking-Zustand nochmals demonstriert. Er liegt bei allen Generatoren jedoch nur in einem bestimmten Bereich, nämlich in dem sogenannten Haltebereich H des Generators vor. Nur in diesem Bereich, der einem bestimmten Strom I der Stromversorgungsschaltung 17 bzw. einer bestimmten entsprechenden optischen Leitung Pₒₚₜ entspricht, ist die Synchronisierung gegeben. Erfolgt eine zu starke "Verstimmung" so wird der Haltebereich H verlassen und der Generator tritt in den Freilaufbereich F über, das heißt, er ist nicht mehr synchronisiert. Im mittleren Diagramm der Figur 6 ist die Amplitude am Ausgang A des Mikrowellen generators in Abhängigkeit von dem Strom I bzw. der optischen Leistung Pₒₚₜ dazu dargestellt. Die oberen beiden Diagramme der Figur 6 betreffen eine Schaltungsanordnung gemäß dem Ausführungsbeispiel der Figur 1, das heißt, wenn nur ein Referenzsignal mit einer bestimmten Referenzfrequenz vorliegt.

Im unteren Diagramm der Figur 6 wird nun auf der Grundlage der vorhergehenden Ausführungen die Funktionsweise besonders einfach deutlich, die mittels des Ausführungsbeispiels der Figur 3 erzielbar ist. Wird nämlich mittels der optischen Leistung Pₒₚₜ des Steuersignals 7 der Strom I der Stromversorgungsschaltung derart variiert, daß die Schwingschaltung 13 den momentan vorliegenden Haltebereich H verläßt und in einen neuen Fang- bzw. Haltebereich H "einrastet", geschieht dies gegebenenfalls unter Durchlaufen eines zwischen diesen beiden Haltebereichen H liegenden Freibereichs F. Wird davon ausgegangen, daß zunächst eine bestimmte Referenzfrequenz eines momentan wirkenden Referenzsignals vorliegt, die den Mikrowellengenerator 1 auf der Frequenz f_{sync1} hält, so kann durch Beeinflussung mit dem Steuersignal 7 erzielt werden, daß dieser zugeordnete Haltebereich verlassen wird und der Generator in den folgenden Fang- bzw. Haltebereich springt, der einer anderen Referenzfrequenz des entsprechenden Modulationssignals zugeordnet ist, so daß nunmehr der Mikrowellengenerator 1 mit der Frequenz f_{sync2} schwingt usw.. Auf diese Art und Weise ist es möglich, mittels des Steuersignals 7 die jeweils durch Injection-Locking synchronisierte Frequenz (Kanal) des Mikrowellengenerators 1 zu verändern.

## Patentansprüche

1. Mikrowellengenerator, dessen Mikrowellenfrequenz mittels einer Referenzfrequenz eines Referenzsignals auf optischem Wege phasenstarr synchronisiert ist, wobei mindestens einem Bereich einer elektronischen Schaltungsanordnung des Mikrowellen generators ein optisches Referenzträgersignal zugeführt wird, das mit der Referenzfrequenz moduliert ist, **dadurch gekennzeichnet,** daß die Schaltungsanordnung (16) zwei Bauelemente (Q1 bis Q6; Q10, Q11) auf der Basis von Halbleitertypen unterschiedlichen Bandabstands aufweist, die derart gewählt sind, daß das eine, erste, einem ersten Halbleitertyp angehörende Bauelement optisch auf das Referenzträgersignal (3) und somit auf die Referenzfrequenz (f₁;Mod1 ... Modn) zur Erzielung der Synchronisierung anspricht, und daß das andere, zweite, einem zweiten Halbleitertyp angehörende Bauelement -unabhängig von dem Ansprechen des ersten Bauelements- auf ein in der Frequenz vom Referenzträgersignal (3) abweichendes optisches Steuerungträgersignal (6) reagiert, mit dessen aufmoduliertem Steuersignal (7) eine Steuerung der Amplitude des ersten Bauelements erfolgt.

2. Mikrowellengenerator nach Anspruch 1, **dadurch gekennzeichnet,** daß die Bauelemente beider Halbleitertypen auf einem gemeinsamen Wafer (Substrat), vorzugsweise monolitisch integriert, angeordnet sind.

3. Mikrowellen generator nach einem der vorhergehenden Ansprüche, **dadurch gekennzeichnet,** daß die Halbleitertypen Silizium (Si) aufweisen.

4. Mikrowellengenerator nach einem der vorhergehenden Ansprüche, **dadurch gekennzeichnet,** daß das Bauelement des ersten Halbleitertyps mindestens ein Silizium-Germanium-Transistor, insbesondere ein Silizium-Germanium-Hetero-Bipolar-Transistor (Si-Ge HBT) ist.

5. Mikrowellengenerator nach einem der vorhergehenden Ansprüche, **dadurch gekennzeichnet**, daß der erste Halbleitertyp auf Licht mit einer Wellenlänge von ca. 1,3µm photoelektrisch reagiert.

6. Mikrowellengenerator nach einem der vorhergehenden Ansprüche, **dadurch gekennzeichnet,** daß das Bauelement des zweiten Halbleitertyps mindestens ein Silizium-Bipolar-Transistor (Si-bip.T) ist.

7. Mikrowellengenerator nach einem der vorhergehenden Ansprüche, **dadurch gekennzeichnet,** daß der zweite Halbleitertyp auf Licht mit einer Wellenlänge von ca. 800 bzw. 980nm photoelektrisch reagiert.

8. Mikrowellengenerator nach einem der vorhergehenden Ansprüche, **dadurch gekennzeichnet,** daß das Bauelement des ersten Halbleitertyps einer Schwingschaltung (13) des Mikrowellenoszillators (1) angehört.

9. Mikrowellengenerator nach einem der vorhergehenden Ansprüche, **dadurch gekennzeichnet**, daß das Bauelement des zweiten Halbleitertyps einer die Schwingschaltung (13) versorgenden Stromversorgungsschaltung (17) des Mikrowellenoszillators (1) angehört.

10. Mikrowellengenerator nach einem der vorhergehenden Ansprüche, **dadurch gekennzeichnet**, daß das Steuersignal (7) derart gewählt wird, daß es die Schwingschaltung (13) des Mikrowellenoszillators (1) in einem die phasenstarre Kopplung bewirkenden Haltebereich (H) hält.

11. Mikrowellengenerator nach einem der vorhergehenden Ansprüche, **dadurch gekennzeichnet,** daß das Referenzträgersignal (3) mehrere, in der Frequenz unterschiedliche Referenzsignale (3;Mod1 bis Modn) aufweist, und daß das Steuersignal (7) derart veränderbar ist, daß es die Schwingschaltung (13) unter Verlassen ihres momentanen, einem der Referenzsignale zugeordneten Haltebereichs (H) in einen anderen, einem anderen der Referenzsignale zugeordneten Haltebereich (H), gegebenenfalls unter Durchlaufen eines Freilaufbereichs (F), umsteuert.

12. Optisch gesteuerter Mikrowellengenerator mit einer Schwingschaltung (13) und einem Modulator (15), wobei ein von der Schwingschaltung (13) erzeugter Mikrowellenträger modulierbar ist, dadurch gekennzeichnet, daß die Schwingschaltung (13) *ein Halbleiter-Bauelemente mit einem ersten Bandabstand enthält, und* mit Licht einer ersten Wellenlänge optisch anregbar ist, daß der Modulator (15) *ein Halbleiter-Bauelemente mit einem zweiten Bandabstand enthält und* mit Licht einer zweiten Wellenlänge steuerbar ist und daß die Schwingschaltung gegenüber dem Licht der zweiten Wellenlänge und der Modulator (15) gegenüber dem Licht der ersten Wellenlänge unempfindlich sind.

13. Optisch gesteuerter Mikrowellengenerator nach Anspruch 12, dadurch gekennzeichnet, daß das Licht der ersten und der zweiten Wellenlänge dem optischen Mikrowellengenerator (1) wenigstens in Teilstrecken gemeinsam zugeführt wird.

14. Optisches Übertragungssystem mit einem optischen Sender und einem optischen Empfänger,
- bei dem der optische Sender Licht einer ersten Wellenlänge erzeugt und emittiert und dabei das Licht mit der zweiten Wellenlänge zur Übertragung eines Signales moduliert ist, und
- bei dem der optische Empfänger einen optisch gesteuerten Mikrowellengenerator gemäß Anspruch 13 aufweist.

## Claims

1. A microwave generator whose frequency is optically phase-locked by means of a reference frequency of a reference signal, wherein at least one portion of an electronic circuit arrangement is supplied with an optical reference carrier signal modulated with the reference frequency,
characterized in that the circuit arrangement (16) includes two components (Q1 to Q6; Q10, Q11) based on semiconductor types which are chosen so that one of the two components, the first component, which is of a first semiconductor type, optically responds to the reference carrier signal (3), and thus to the reference frequency (f₁; Mod1...Modn), for achieving synchronization, that - independently of the response of the first component - the other, second component, which is of a second semiconductor type, responds to an optical control carrier signal (6) differing in frequency from the reference carrier signal (3), and that a control signal (7) modulated onto said optical control carrier signal (6) is used to control the amplitude of the first component.

2. A microwave generator as claimed in claim 1,
characterized in that the components of both semiconductor types are arranged, preferably monolithically integrated, on a common wafer (substrate).

3. A microwave generator as claimed in any one of the preceding claims, characterized in that the semiconductor types include silicon (Si).

4. A microwave generator as claimed in any one of the preceding claims, characterized in that the component of the first semiconductor type is at least one silicon-germanium transistor, particularly a silicon-germanium heterobipolar transistor (Si-Ge HBT).

5. A microwave generator as claimed in any one of the preceding claims, characterized in that the first semiconductor type photoelectrically responds to light having a wavelength of approximately 1.3 µm.

6. A microwave generator as claimed in any one of the preceding claims, characterized in that the component of the second semiconductor type is at least one silicon bipolar transistor (Si bip.T).

7. A microwave generator as claimed in any one of the preceding claims, characterized in that the second semiconductor type photoelectrically responds to light having a wavelength of approximately 800 or 980 nm.

8. A microwave generator as claimed in any one of the preceding claims, characterized in that the component of the first semiconductor type forms part of an oscillator circuit (13) of the microwave generator (1).

9. A microwave generator as claimed in any one of the preceding claims, characterized in that the component of the second semiconductor type forms part of a power supply circuit (17) for the oscillator circuit (13).

10. A microwave generator as claimed in any one of the preceding claims, characterized in that the control signal (7) is chosen to hold the oscillator circuit (13) of the microwave generator in a locking range (H).

11. A microwave generator as claimed in any one of the preceding claims, characterized in that the reference carrier signal (3) comprises a plurality of reference signals (3; Modl to Modn) of unequal frequency, and that the control signal (7) can be changed to switch the oscillator circuit (13) from its current locking range (H), assigned to one of the reference signals, to another locking range (H), assigned to another one of the reference signals, with the oscillator circuit (13) possibly passing through a free-running range (F).

12. An optically controlled microwave generator (1) comprising an oscillator circuit (13) and a modulator (15) for modulating a microwave carrier generated by the oscillator circuit (13), characterized in that the oscillator circuit (13) comprises semiconductor devices with a first band gap and is excitable optically with light of a first wavelength, that the modulator (15) comprises semiconductor devices with a second band gap and is controllable with light of a second wavelength, and that the oscillator circuit is insensitive to the light of the second wavelength, while the modulator (15) is insensitive to the light of the first wavelength.

13. An optically controlled microwave generator as claimed in claim 12, characterized in that the light of the first wavelength and the light of the second wavelength is transmitted to the optical microwave generator (1) together, at least over sections of a link.

14. An optical transmission system comprising an optical transmitter and an optical receiver
- wherein the optical transmitter generates and emits light of a first wavelength and light of a second wavelength, the light of the second wavelength being modulated for transmitting a signal, and
- wherein the optical receiver includes an optically controlled microwave generator as claimed in claim 13.

## Revendications

1. Générateur hyperfréquence, dont l'hyperfréquence est synchronisée de façon optique en verrouillage de phase à l'aide d'une fréquence de référence d'un signal de référence, dans lequel au moins une plage d'un mode de couplage électronique du générateur hyperfréquence reçoit un signal optique de porteuse de référence qui est modulé par la fréquence de référence, caractérisé en ce que le mode de couplage (16) présente deux composants (Q1 à Q6; Q10, Q11) sur la base de types de semi-conducteur avec un intervalle de bande différent, qui sont choisis de telle sorte que l'un des composants, le premier, appartenant à un premier type de semi-conducteur, répond de façon optique au signal de porteuse de référence (3) et donc à la fréquence de référence (f₁; Mod1 ... Modn) pour atteindre la synchronisation, et en ce que l'autre composant, le deuxième, appartenant à un deuxième type de semi-conducteur, - indépendamment de la réponse du premier composant - réagit en fonction d'un signal optique de porteuse de modulation (6), différent en fréquence du signal de porteuse de référence (3), une commande de l'amplitude du premier composant étant effectuée avec le signal de commande modulé (7) du signal de porteuse de commande.

2. Générateur hyperfréquence selon la revendication 1, caractérisé en ce que les composants des deux types de semi-conducteur sont disposés sur une plaquette (substrat) commune, de préférence intégrés de façon monolithique.

3. Générateur hyperfréquence selon l'une quelconque des revendications précédentes, caractérisé en ce que les types de semi-conducteur présentent du silicium (Si).

4. Générateur hyperfréquence selon l'une quelconque des revendications précédentes, caractérisé en ce que le composant du premier type de semi-conducteur est au moins un transistor au silicium-germanium, en particulier un transistor hétérojonction au silicium-germanium (Si-Ge HBT).

5. Générateur hyperfréquence selon l'une quelconque des revendications précédentes, caractérisé en ce que le premier type de semi-conducteur réagit de façon photoélectrique à une lumière d'une longueur d'onde d'environ 1,3 µm.

6. Générateur hyperfréquence selon l'une quelconque des revendications précédentes, caractérisé en ce que le composant du deuxième type de semi-conducteur est au moins un transistor bipolaire au silicium (Si-bip.T).

7. Générateur hyperfréquence selon l'une quelconque des revendications précédentes, caractérisé en ce que le deuxième type de semi-conducteur réagit de façon photoélectrique à une lumière d'une longueur d'onde d'environ 800 ou 980 nm.

8. Générateur hyperfréquence selon l'une quelconque des revendications précédentes, caractérisé en ce que le composant du premier type de semi-conducteur appartient à un circuit oscillant (13) de l'oscillateur hyperfréquence (1).

9. Générateur hyperfréquence selon l'une quelconque des revendications précédentes, caractérisé en ce que le composant du deuxième type de semi-conducteur appartient à un circuit d'alimentation électrique (17), alimentant le circuit oscillant (13), de l'oscillateur hyperfréquence (1).

10. Générateur hyperfréquence selon l'une quelconque des revendications précédentes, caractérisé en ce que le signal de commande (7) est choisi de telle sorte qu'il maintient le circuit oscillant (13) de l'oscillateur hyperfréquence (1) dans une plage de maintien (H) provoquant le couplage en verrouillage de phase.

11. Générateur hyperfréquence selon l'une quelconque des revendications précédentes, caractérisé en ce que le signal de porteuse de référence (3) présente plusieurs signaux de référence (3; Modl à Modn) différents en fréquence, et en ce que le signal de commande (7) est variable de telle sorte qu'il inverse le circuit oscillant (13) lorsque celui-ci quitte sa plage de maintien (H) momentanée, affectée à l'un des signaux de référence, vers une autre plage de maintien (H), affectée à un autre des signaux de référence, éventuellement en parcourant une plage de régime libre (F).

12. Générateur hyperfréquence à commande optique, avec un circuit oscillant (13) et un modulateur 15), dans lequel une porteuse hyperfréquence générée par le circuit oscillant (13) est modulable, caractérisé en ce que le circuit oscillant contient un composant à semi-conducteur avec un premier intervalle de bande, et peut être excité optiquement par une lumière d'une première longueur d'onde, en ce que le modulateur contient un composant à semi-conducteur avec un deuxième intervalle de bande et peut être commandé optiquement par une lumière d'une deuxième longueur d'onde, et en ce que le circuit oscillant est insensible à la lumière de la deuxième longueur d'onde et le modulateur (15) est insensible à la lumière de la première longueur d'onde.

13. Générateur hyperfréquence commandé de manière optique selon la revendication 12, caractérisé en ce que la lumière des première et deuxième longueurs d'onde parvient de manière groupée jusqu'au générateur hyperfréquence (1) au moins par segments.

14. Système de transmission optique avec un émetteur optique et un récepteur optique, dans lequel l'émetteur optique génère une lumière d'une première longueur d'onde et la lumière de la deuxième longueur d'onde est alors modulée pour transmettre un signal, et dons lequel le récepteur optique présente un générateur hyperfréquence commandé de manière optique selon la revendication 13.
